# EUROPEAN PATENT APPLICATION

(11) **EP 2 375 466 A1**
(43) Date of publication of application: **12.10.2011**
(21) Application number: 09837526.4
(22) Date of filing: 11.09.2009
(51) Int. Cl.: H01L 51/50, H05B 33/02, H05B 33/10, H05B 33/12

(54) **ORGANIC ELECTROLUMINESCENCE DISPLAY DEVICE AND METHOD FOR PRODUCING THE SAME**

(30) Priority: 07.01.2009 JP 2009001935
(71) Applicant: Sharp Kabushiki Kaisha, Osaka-shi, Osaka 545-8522 (JP)
(72) Inventor: MINOURA, Kiyoshi, Osaka 545-8522 (JP); ASAOKA, Yasushi, Osaka 545-8522 (JP); YASUMATSU, Takuto, Osaka 545-8522 (JP)
(74) Representative: Hoffmann, Jörg Peter
(86) International application number: PCT/JP2009/065927
(87) International publication number: WO 2010/079640

(57) **Abstract**

It is an object of the present invention to provide an organic electroluminescent display device and a production method thereof with which an organic electroluminescent display device having a high extraction efficiency is produced in a high yield. The present invention is an organic electroluminescent display device, comprising: a component placement substrate having an organic electroluminescence element; a circuit board having a driver circuit for the organic electroluminescence element, the component placement substrate and the circuit board being joined to each other; and a conductor in a clearance between the component placement substrate and the circuit board, the component placement substrate comprising in this order from an observation face side: a transparent separation layer; a light-scattering layer; a transparent electrode; a light-emitting layer; and the reflective electrode, wherein the conductor electrically connects the reflective electrode to an electrode of the driver circuit.

## Description

### TECHNICAL FIELD

The present invention relates to an organic electroluminescent display device and a production method thereof. More specifically, it relates to an organic electroluminescent display device having a laminate of a substrate with a light-emitting layer and the like and a substrate with a thin film transistor (TFT) element and the like; and a production method thereof.

### BACKGROUND ART

Organic electroluminescence (hereinafter, also referred to as "EL") display devices are being briskly developed as promising display devices of the next generation and has been gradually practically used. The organic EL display device can be classified into a top emission type and a bottom emission type in terms of the light extraction directions. The top emission type organic EL display device has a film configuration comprising a metal electrode, a light-emitting layer, and a transparent electrode in this order on substrates such as a glass substrate. The bottom emission type organic EL display device has a film configuration comprising a transparent electrode, a light-emitting layer, and a metal electrode in this order on a substrate such as a glass substrate. According to the difference in the film configuration, the top emission type organic EL display device emits light in a direction opposite to the element substrate on the basis of the light-emitting layer while the bottom emission type organic EL display device emits light in the direction of the element substrate on the basis of the light-emitting layer. As thus described, the top emission type organic EL display device and the bottom emission type organic EL display device are different in the extraction direction of light from the light-emitting layer.

In both the top emission type and bottom emission type organic EL display devices, light emission from the light-emitting layer is attenuated by total reflection. Accordingly, the extraction efficiency of extracting the light emission from the light-emitting layer to the outside of an element is only about 20 to 25%, and the extraction efficiency is required to be improved. In order to improve the extraction efficiency, light emission from the light-emitting layer needs to be extracted from the pixel including the same light-emitting layer. For that purpose, it is necessary to scatter the light emission from the light-emitting layer and then guide the scattered light to the outside of the element. Patent Document 1, for example, proposes providing an optical member having a reflection function as a means for scattering the light emission from the light-emitting layer, and proposes a corner cube array known as an optical member having a high scattering effect.

The means for guiding the scattered light to the outside of the element needs to be provided on the light-emitting side, and is preferably as low a refractive index as possible and as thin as possible. Patent Document 2, for example, proposes a method of providing a low refractive index layer, such as a metallic thin film, in the vicinity of the light-emitting layer as a light guide means. The low refractive index layer is preferably transparent in consideration of the light transmittance. A gas layer made of gas such as air may be mentioned as a thin, transparent low refractive index layer. In the case where the gas layer is provided as the low refractive index layer on the light emitting side, total reflection arises at an interface between the gas layer and a layer whose refractive index is higher than the gas layer, and scattered light from the light-emitting layer can be efficiently emitted out. In the case of a top emission type organic EL display device, an EL element is formed on the main surface of the component placement substrate, and thereafter the low refractive index layer is formed. Accordingly, the application is easy.

However, since, in the bottom emission type organic EL display device, a low refractive index layer has to be formed between the component placement substrate and the EL element, it poses a problem in determining in which step a low refractive index layer is formed. Since the light-emitting layer of the organic EL element is typically formed by vacuum film formation, for example, it is difficult to form a gas layer that serves as a low refractive index layer before film formation of the light-emitting layer. In the case where an optical member having a high scattering effect, such as the above-mentioned corner cube array, is provided, formation of a gas layer is difficult in consideration of the method of forming a corner cube array. The corner cube array is formed by a Photo-Polymer transfer method (hereinafter, also referred to as a 2P transfer method). In the 2P transfer method, liquid ultraviolet-ray (UV) curing resin is applied onto a supporting substrate, and the corner cube array is formed by application of UV light under pressure with a die. Therefore, UV curing resin before curing is liquid, and the gas layer is difficult to maintain. Thus, in the bottom emission type organic EL display device, it is difficult to form the gas layer in the initial process before formation of an organic EL element.

Conventionally, the method of forming a functional element, such as a thin film transistor (TFT), on a supporting substrate, separating the formed functional element from the supporting substrate, and pasting the functional element to another substrate is proposed for the purpose of producing a thinner, lighter display device. According to this method, in the case of forming a functional element, a substrate excellent in heat resistance and the like properties, such as a glass substrate, can be used as a supporting substrate, and the separated functional element can be pasted to another substrate, such as a thinner, lighter resin film. Therefore, a thinner, lighter display device can be produced.

Examples of the method for separating a functional element from a supporting substrate include: a method of removing a supporting substrate by etching or polishing (see, for example, Patent Document 3); a method of providing, on a supporting substrate, a separation layer made of an oxide layer that comes into contact with a metal layer or a nitride layer, and mechanically separating the functional element from the separation layer (see, for example, Patent Document 4); a method of charging a hydrogen ion into a separation film made of amorphous silicone (a-Si), heating the separation film, and thereby separating the separation film from the substrate (see, for example, Patent Document 5); and a method of forming a separation layer on the supporting substrate, applying laser to the separation layer to change the adhesion, and thereby removing the substrate (see, for example, Patent Document 6).

If the above-mentioned method of separating a functional element is applied to a bottom emission type organic EL display device, a low refractive index layer may be formed after pasting an organic EL element to another substrate. For example, a scattering means and an organic EL element may be formed on the main surface of a supporting substrate and separated from the supporting substrate, and pasted to another substrate to form a gas layer. In this case, in consideration of the light extraction efficiency, the following three points are required: the light transmittance is maintained without any coloring and the like on the surface separated from the supporting substrate; the treatment does not give any damage to the light-emitting layer; and a large area can be separated in a high yield on the entire surface.

However, in the technique of removing a supporting substrate by etching, polishing, or the like as described in Patent Document 3, a light-emitting layer of an organic EL element may be deteriorated with an etching chemical or the like. The technique of mechanically separating a functional element as described in Patent Document 4 is simple and preferable, and this method is applicable to separation of a functional element such as a TFT. However, the application of the technique of mechanically separating a functional element is difficult in the case where the functional element is an organic EL element, and a resin structure such as a corner cube array is provided. This is because the adhesion between the resin structure and the organic EL element is often lower than the adhesion between the supporting substrate and the separation layer, and mechanical separation tends to cause degradation of elements.

In the case where the separation layer is provided between the supporting substrate and the resin structure, uniform separation is difficult without providing a control means for separation, and the tendency is remarkable particularly in using a supporting substrate having a large area. Accordingly, separation in a high yield is difficult. The method of using amorphous silicone (a-Si) as a separation film as described in Patent Document 5 is not applicable because the separated face does not have transparency. In addition, in the method of using laser application as described in Patent Document 6, the separation film is problematically colored by laser application, leading to reduction in transparency.

[Patent Document 1]
   Japanese Kokai Publication No. 2002-198184
[Patent Document 2]
   Japanese Kokai Publication No. 2004-22176
[Patent Document 3]
   Japanese Kokai Publication No. 2007-88491
[Patent Document 4]
   Japanese Kokai Publication No. 2003-174153
[Patent Document 5]
   Japanese Kokai Publication No. 2004-335968
[Patent Document 6]
   Japanese Kokai Publication No. 2004-140381

### SUMMARY OF THE INVENTION

It is an object of the present invention to provide an organic electroluminescent display device and a production method thereof with which an organic electroluminescent display device having a high extraction efficiency is produced in a high yield.

The present inventors made various investigations on the configuration of an organic EL display device that can efficiently extract light from a light-emitting layer, and noted a low refractive index layer provided in the vicinity of the light-emitting layer. They found that when the low refractive index layer is made of a gas layer, an organic EL display device having a high extraction efficiency is produced. They also found that a gas layer can be formed in the vicinity of the light-emitting layer even in a bottom emission type organic EL display device in which the gas layer as a low refractive index layer has been difficult to form by applying a method of separating a functional element from a supporting substrate, which has been employed in producing a display device provided with a functional element such as a TFT, specifically, a method of separating a functional element, such as a TFT formed on the supporting substrate, from the supporting substrate and pasting the functional element to another substrate. They also found that an element can be separated in a high yield on the entire surface of the substrate without damaging the light-emitting layer even with a supporting substrate having a large area by a combination of partial laser application and mechanical separation. As a result, the above-mentioned problems have been admirably solved, leading to completion of the present invention.

### DISCLOSURE OF THE INVENTION

That is, the present invention is an organic electroluminescent display device, comprising: a component placement substrate having an organic electroluminescence element; a circuit board having a driver circuit for the organic electroluminescence element, the component placement substrate and the circuit board being joined to each other; and a conductor in a clearance between the component placement substrate and the circuit board, the component placement substrate comprising in this order from an observation face side: a transparent separation layer; a light-scattering layer; a transparent electrode; a light-emitting layer; and the reflective electrode, wherein the conductor electrically connects the reflective electrode to an electrode of the driver circuit.

The present invention is also a method for producing an organic electroluminescent display device, the organic electroluminescent display device comprising: a component placement substrate having an organic electroluminescence element; and a circuit board having a driver circuit for the organic electroluminescence element, the component placement substrate and the circuit board being joined to each other; the method comprising the steps of: forming a transparent separation layer on a main surface of a supporting substrate; forming a light-scattering layer on the transparent separation layer; forming an organic electroluminescence element comprising a transparent electrode, a light-emitting layer, and a reflective electrode in this order on the light-scattering layer; disposing a conductor material on at least one of a surface on a side of the supporting substrate including the organic electroluminescence element and a main surface of the circuit board; pasting together the component placement substrate and the circuit board so that the reflective electrode and the electrode of the driver circuit are connected via the conductor material; applying a laser to part of the transparent separation layer from a side of a main surface of the supporting substrate opposite to the side including the organic electroluminescence element to modify the part of the transparent separation layer; and separating the supporting substrate from the modified part of the transparent separation layer.
The present invention will be described in detail.

In the organic EL display device of the present invention, the component placement substrate having an organic EL element and the circuit board having a driver circuit for the organic EL element are joined to each other. The component placement substrate joined to the circuit board comprises in this order from an observation face side: a transparent separation layer; a light-scattering layer; a transparent electrode; a light-emitting layer; and a reflective electrode (metal electrode). Light from the light-emitting layer is extracted from a surface on a side including the transparent separation layer. Therefore, the organic EL display device according to the present invention is a top emission type, though it has the same film configuration as that of a bottom emission type.
The organic EL display device may be generally referred to as an organic light emitting diode (OLED) display device.

In the organic EL display device having such a configuration, a low refractive index layer whose refractive index is lower than that of the substrate made of glass, resin, or the like can be easily formed on a surface of the component placement substrate on a side provided with the transparent separation layer. As a result, total reflection arises at an interface between the low refractive index layer, and the component placement substrate and/or the transparent separation layer, and therefore light scattered from the light-emitting layer can be efficiently emitted out. The low refractive index layer is not particularly limited, and the most inexpensive and simplest configuration is, for example, such that air on the side including the transparent separation layer is used as a low refractive index layer. As a result, in the present invention, also in the organic EL display device having a bottom emission type film configuration in which the low refractive index layer has been conventionally difficult to form, the low refractive index layer can be easily formed, and an organic EL display device having a high external efficiency can be achieved.

In the organic EL display device of the present invention, the transparent separation layer provided in the component placement substrate absorbs light to be applied, and thereby produces separation in the layer and/or at the interface (interlayer separation and interfacial separation). Preferably, the transparent separation layer is such that light application causes the bonding strength between atoms or molecules of the substance of the transparent separation layer to disappear or decrease, or causes ablation and results in interlayer separation and/or interfacial separation. A transparent separation layer may be formed of such a material as a polyimide film. The transparent separation layer is formed on the light-scattering layer, is not particularly limited in its arrangement shape, and may be formed on the entire main surface of the light-scattering layer or part of the main surface thereof. In the organic EL display device of the present invention, the transparent separation layer can be observed with a scanning electron microscope (EMS) and the like, for example.

The transparent separation layer is not particularly limited in its thickness, is preferably as thin as possible, and preferably has a thickness of 40 nm to 300 nm, for example. A thickness of the transparent separation layer of less than 40 nm makes it difficult to form a transparent separation layer, and a thickness thereof exceeding 300 nm tends not to give a high light guide.

The light-scattering layer is a layer having light scattering properties of scattering the light from the light-emitting layer, and examples thereof include a layer formed of a material such as an acrylic or urethane photocurable resin. In particular, the light-scattering layer is preferably a corner cube array. The corner cube array is an optical member comprising multiple pyramid unit structures (corner cubes) obtained by combining planes having properties of reflecting light and having high light scattering properties. Light incident from the bottom side of the corner cube array has the retro-reflective function of repeating reflection at a plane and returning to the incident direction, and therefore the corner cube array is a retro-reflective substrate. Black display can be achieved with the corner cube array and without a circularly polarizing plate, leading to effective improvement in extraction efficiency.

The mere use of the corner cube array as a scattering means results in higher scattering, but the light emitted in the light-emitting layer is optically guided and emitted out of the panel at a position distant from the emission point. In the present invention, the low refractive index layer is formed on the light-scattering layer as mentioned above. The combination of the corner cube array with the low refractive index layer as a scattering means can further improve the extraction efficiency.

In the component placement substrate, a transparent electrode, a light-emitting layer, and a reflective electrode configures the organic EL element. As a transparent electrode, metal oxides such as indium tin oxide (ITO) and indium zinc oxide (IZO) are suitably used. In addition to the light-emitting layer, a hole transport layer, a hole injection layer, an electron transport layer, an electron injection layer, and the like may be disposed between the reflective electrode and the transparent electrode.

The circuit board has the driver circuit for the organic EL element. This driver circuit is not particularly limited as long as it is a circuit for driving an organic EL element provided in the component placement substrate. The driver circuit comprises a wiring for transmitting a signal to the organic EL element, and an element for controlling the drive of the organic EL element. Examples of the wiring for transmitting a signal to the organic EL element include a gate line and a source line. Examples of the element for controlling the drive of the organic EL element include a TFT. The driver circuits provided in the circuit board need not to be all circuits required for driving the organic EL element, and may be ones for driving an organic EL element with an external circuit provided outside the component placement substrate and the circuit board, other circuits provided in the component placement substrate, and the like. The configuration of the circuit board is not particularly limited provided the circuit board has the above-mentioned driver circuit, and for example, the configuration in which a wiring, an electrode, an electric element, and the like are laminated on the substrate via an insulating film is preferable.

The organic EL display device of the present invention has a conductor that electrically connects the reflective electrode to the electrode of the driver circuit in a clearance between the component placement substrate and the circuit board. The present common display has at least tens of thousands of pixels, and all the pixels need to be electrically connected upon pasting together a substrate including a TFT element and a substrate having the light-emitting layer.

In the present invention, the component placement substrate and the circuit board are preferably connected via the conductor formed of a plastic deformable material. In the case where the conductor is formed of a plastic deformable material (hereinafter, also referred to as a conductor material), the conductor material can be deformed according to the shape of a substrate surface upon pasting the component placement substrate and the circuit board together. Accordingly, this makes it possible to surely electrically contact the electrode of the organic EL element to the electrode of the driver circuit and secure a large contact area. Consequently, the margin of the distance between substrates in the production process (a design allowable error in consideration of the electrical contact via the conductor) becomes large.

Therefore, the conductor material is plastic deformable in the case of pasting the component placement substrate and the circuit board together, and may not be plastic deformable after pasting the component placement substrate and the circuit board together. The plastic deformation of the conductor material causes the shape of the conductor to conform to the shape of the surface of the component placement substrate and/or the circuit board.

Examples of the conductor material include a conductive paste, an anisotropic conductive film, and solder. Of these, the conductive paste is preferable in that it has excellent shape conformability and good shape retention, and the electrode of the organic EL element and the electrode of the driver circuit can be electrically connected at mild temperature and pressure conditions.
That is, the conductor is preferably formed of the conductive paste. The conductive paste is usually a material containing a solid content and a solvent.

The arrangement of the conductor is not particularly limited provided the electrode of the organic EL element and the electrode of the driver circuit are electrically connected. In order to conduct the organic EL element disposed in each pixel and the driver circuit provided in the circuit board each with a conductor, the conductor is preferably individually disposed in each pixel. For example, in the structure having the configuration of electrically connecting and pasting together the component placement substrate and the circuit board in all the pixels, by pasting them together with the conductor formed of a material for plastic deformation, the certainty of electrical contact via the conductor can be improved, a large contact area can be secured, and leakage between pixels and generation of voids can be suppressed.
Placement of a spacer made of a non-plastic deformable material makes the effects more remarkable.

In the organic EL device of the present invention may have a spacer in at least one of the component placement substrate, the circuit board, and a clearance between the component placement substrate and the circuit board. This spacer is preferably made of a non-plastic deformable material. Since the spacer is made of a non-plastic deformable material, the spacer can appropriately define the distance between the component placement substrate and the circuit board even if the conductor material is plastic deformed upon pasting the component placement substrate and the circuit board together. As a result, the distance between substrates becomes shorter, and the conductor material can be prevented from being excessively pushed out. Thus, a short circuit between pixels and the like can be prevented.

The spacer is not particularly limited provided it is made of a non-plastic deformable material, and may or may not be conductive. The spacer is not particularly limited provided the existence thereof substantially determines the distance between the two substrates. Examples thereof include: a projection (hereinafter, also referred to as a bump) formed in at least one of the component placement substrate and the circuit board; and a spacer (hereinafter, also referred to as a dispersed spacer) that is provided independently from the component placement substrate and the circuit board. The projection is formed on a substrate by a photolithography method, for example.

Examples of the dispersed spacers include: particulate or bar spacers such as plastic beads and glass beads; and fiber spacers such as glass fibers. The dispersed spacers are dispersed on the substrate, for example, by a method with a dispenser and an inkjet method. The dispersed spacer may be kneaded into a conductor material and disposed on the substrate, and examples of a preferable embodiment of the dispersed spacer include an embodiment in which the dispersed spacer is contained in a conductor.

In the present invention, "non-plastic deformability" refers to the property of substantially no deformation or preferably no deformation upon pressurization in the case of pasting the component placement substrate and the circuit board together. The "non-plastic deformability" may also include the property of substantially recovering the original shape after deformation upon pressurization in the case of pasting the component placement substrate and the circuit board together if the reliability of the electrical connection by a conductor is securable. Meanwhile, "plastic deformability" refers to the property of keeping deformation without recovering the original shape before the deformation upon pressurization in the case of pasting the component placement substrate and the circuit board together. The pressurization condition in the case of pasting the component placement substrate and the circuit board together is usually a pressure of 1 kg/cm² or less.

The component placement substrate may further comprise a protective substrate disposed via another clearance spacedly from the transparent separation layer on the observation face side. In the case where the transparent separation layer is partially formed on the main surface of the light-scattering layer, a gas layer is formed between the component placement substrate and the protective substrate. This gas layer is typically air.
The use of the gas layer as a low refractive index layer can contribute to improvement in the extraction efficiency from the light-emitting layer.

The protective substrate is not particularly limited, may be appropriately selected depending on the application, and is preferably a glass substrate or a resin film. In the case where the protective substrate is a resin film, the resin film is thin and light. Therefore, a thinner, lighter organic EL display device can be produced. Since the resin film has flexibility, a flexible organic EL display device can be produced. The protective substrate may be a color filter substrate.

The configuration of the organic EL display device of the present invention is not particularly limited provided it essentially includes such components. The organic EL display device may or may not include other components.

The method for producing an organic electroluminescent display device comprises the steps of: forming a transparent separation layer on a main surface of a supporting substrate; forming a light-scattering layer on the transparent separation layer; forming an organic electroluminescence element comprising a transparent electrode, a light-emitting layer, and a reflective electrode in this order on the light-scattering layer; disposing a conductor material on at least one of a surface on a side of the supporting substrate including the organic electroluminescence element and a main surface of the circuit board; pasting together the component placement substrate and the circuit board so that the electrode of the organic EL element and the electrode of the driver circuit are connected via the conductor material; applying a laser to part of the transparent separation layer from a side of a main surface of the supporting substrate opposite to the side including the organic electroluminescence element to modify the part of the transparent separation layer; and separating the supporting substrate from the modified part of the transparent separation layer.

According to such a configuration, part of the transparent separation layer can be modified by partial laser application in the laser application step. The modified transparent separation layer is readily separated by application of mechanical external force, and the supporting substrate is easily separated in the separation step. As a result, even with a supporting substrate having a large area, the supporting substrate can be separated on the entire surface of the substrate in a high yield. Therefore, for example, it is effective particularly in forming multiple organic EL element substrates at once with one supporting substrate. Thus, in the present invention, upon separation of a supporting substrate, by intentionally triggering separation by use of partial laser application as a control means for separation, the supporting substrate having a large area can be separated in a high yield even by a mechanical technique in the subsequent separation step. The unmodified transparent separation layer in the laser application step remains on the main surface of the light-scattering layer.

In the step of forming a transparent separation layer, the supporting substrate is a substrate made of a glass substrate, a plastic film, and the like. If heat resistance is needed, a plastic film that weaves glass fibers and the like into a substrate may be used. The material is not particularly limited, and may be appropriately selected if necessary. The supporting substrate may have a single layer structure or a laminated structure. The transparent separation layer is made of a polyimide film and the like, and is formed on the main surface of the supporting substrate by applying a resin solution, laminating a resin film, or the like. Although not particularly limited, the transparent separation layer preferably has a thickness of 40 nm to 300 nm.

In the step of forming a light-scattering layer, the light-scattering layer is not particularly limited provided it has light scattering properties. In the present invention, a corner cube array having high light scattering properties can be suitably used. The method for forming the corner cube array is not particularly limited, and may be formed by a known method.

In the process of forming a laminated body, the organic EL element comprises in this order the transparent electrode, the light-emitting layer, and the reflective electrode. The method for forming the organic EL element is not particularly limited, and may be formed by a known method.

The process of disposing a conductor material is a process of disposing a conductor material on at least one of the component placement substrate and the circuit board. Examples of the conductor material include ones described above. Examples of the method of disposing the conductor material include a method of disposing the conductor material with a dispenser and an ink jet method if the conductor material is a conductive paste.

The pasting step is a step of pasting the component placement substrate and the circuit board together so as to connect the electrode of the organic EL element and the electrode of the driver circuit via the conductor material. Examples of the method used in this step include the method of aligning both substrates so as to align the positions of marks for pasting both substrates together and applying pressure to both substrates in vertical directions.

In the laser application step, laser is partially applied to the transparent separation layer from a side of a main surface of the supporting substrate opposite to the side including the organic EL element. Such laser application is readily performed with a mask. Since the transparent separation layer irradiated with laser is modified, the transparent separation layer is readily separated in the subsequent separation step. When laser is applied to the transparent separation layer in a display region, the transparent separation layer is colored. Therefore, the laser is partially applied so as not to laser irradiate the display region. The transparent separation layer remaining after separation is not modified by the laser application, and therefore the transparency is not impaired.

The laser application is not particularly limited, and examples thereof include gas laser and solid (semiconductor) laser. An excimer laser using ultraviolet rays is preferable among these. The energy density of a laser beam to be applied, particularly the energy density of the excimer laser, is preferably about 150 mJ/cm² to 250 mJ/cm², and more preferably about 190 mJ/cm² to 210 mJ/cm². The laser application time is preferably about 10 nsec to 200 nsec, and more preferably about 10 nsec to 50 nsec.

In the separation step, the supporting substrate is separated from the light-scattering layer. As a result, part of the transparent separation layer remains on the surface of the light-scattering layer including the transparent separation layer, the supporting substrate is lost on this surface, this surface comes into contact with a gas (air) with a low refractive index, and the extraction efficiency can be improved as described above.

The configuration of the method for producing the organic EL display device of the present invention is not particularly limited by other steps provided such a component is indispensable.

As a preferable embodiment according to the present invention, the laser application step includes applying a laser via a mask on an outer edge of a display region of the display device and/or between pixel regions in the display region. This step facilitates the distinction between a laser irradiation region and a laser non-irradiation region. As a preferable embodiment of the present invention, a color filter may be used as the mask in the case where the color filter is provided in the component placement substrate. Such a configuration enables laser irradiation on the outer edge of the display region of the display device and/or between pixel regions in the display region.

The production method may further include disposing a spacer on at least one of the component placement substrate and the circuit board. It is preferable to dispose a spacer made of a material harder than a conductor material. The expression "harder than a conductor material" used herein means that a higher pressure is required to be applied to a material than to a conductor material for plastic deformation. In the case of pasting the component placement substrate and the circuit board together and deforming plastically the conductor material, such a spacer also appropriately defines the distance between the component placement substrate and the circuit board. As a result, the conductor material can be prevented from being excessively pushed out because of a narrow space between the component placement substrate and the circuit board. Thus, a short circuit between pixels and the like can be prevented.

Examples of the method of disposing a spacer include: a method in which a photosensitive resin film is patterned by a photolithographic method, and a bump is formed in a desired position, in the case where the spacer is a bump; and a method of disposing a spacer with a dispenser, and a method of dispersing a spacer by an inkjet method, in the case where a spacer is a particle spacer.

In the organic EL display device of the present invention produced by the production method, an organic EL element having a bottom emission type element structure is transferred, and thereby light is finally extracted from the upper surface of the substrate. Accordingly, the organic EL display device finally produced is an organic EL element whose film configuration is a bottom emission type and which has a top emission structure.

An organic EL display device having such a configuration can achieve a high aperture ratio, an advantage of the top emission type, and simultaneously can prevent degradation of an electrode, a problem to be solved in the production process of the top emission type. That is, such an organic EL display device has a higher aperture ratio compared with a typical bottom emission type organic EL display device. In the present technology, for example, a bottom emission type organic EL display device for a high definition display exceeding 200 ppi (pixels per inch) has a very low aperture ratio and therefore is particularly advantageous in such a case. Differently from a typical top emission type organic EL display device, the deterioration of an organic EL material can be prevented in the production process even if an electrode is formed using a metal oxide. Therefore, the reduction in the transmittance in the case of forming an electrode using a metallic thin film is avoidable.

### EFFECT OF THE INVENTION

The present invention does not have a supporting substrate that comes into contact with the face of the light-scattering layer including the transparent separation layer, and the face comes into contact with a low refractive index layer, leading to improvement in the external efficiency of light emission. An organic EL element is separated from a supporting substrate by combining partial laser application with mechanical separation, and therefore, a large area can be separated in a high yield, resulting in excellent mass production.

### BRIEF DESCRIPTION OF THE DRAWINGS

[Fig. 1]

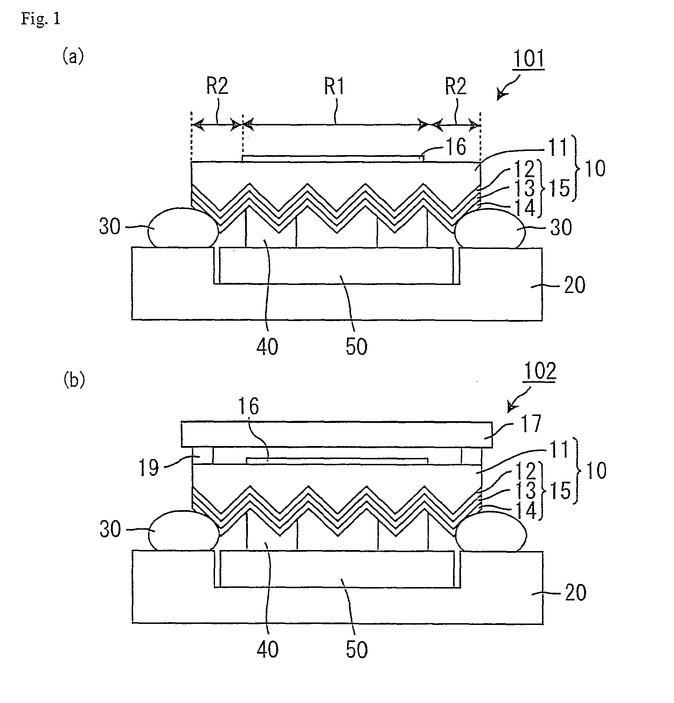

   Fig. 1(a) and 1(b) are cross-sectional views illustrating the configuration of a bottom emission type organic EL display device of Embodiment 1.
[Fig. 2-1]

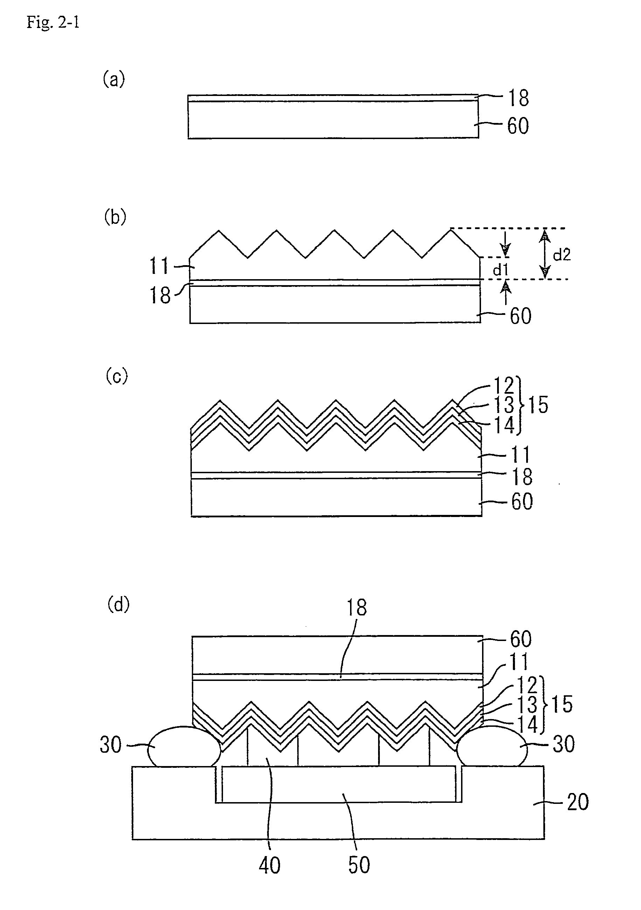

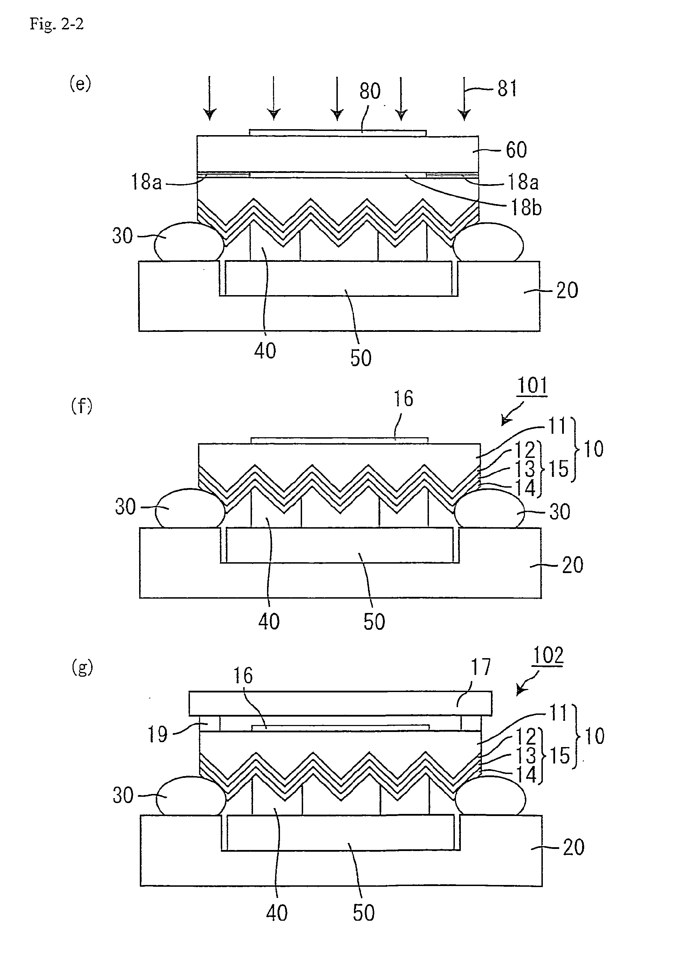

   Figs. 2-1(a) to 2-1(d) are cross-sectional views schematically illustrating the production process of the bottom emission type organic EL display device of Embodiment 1.
[Fig. 2-2]
   Figs. 2-2(e) to 2-2(g) are cross-sectional views schematically illustrating the production process of the bottom emission type organic EL display device of Embodiment 1.
[Fig. 3]

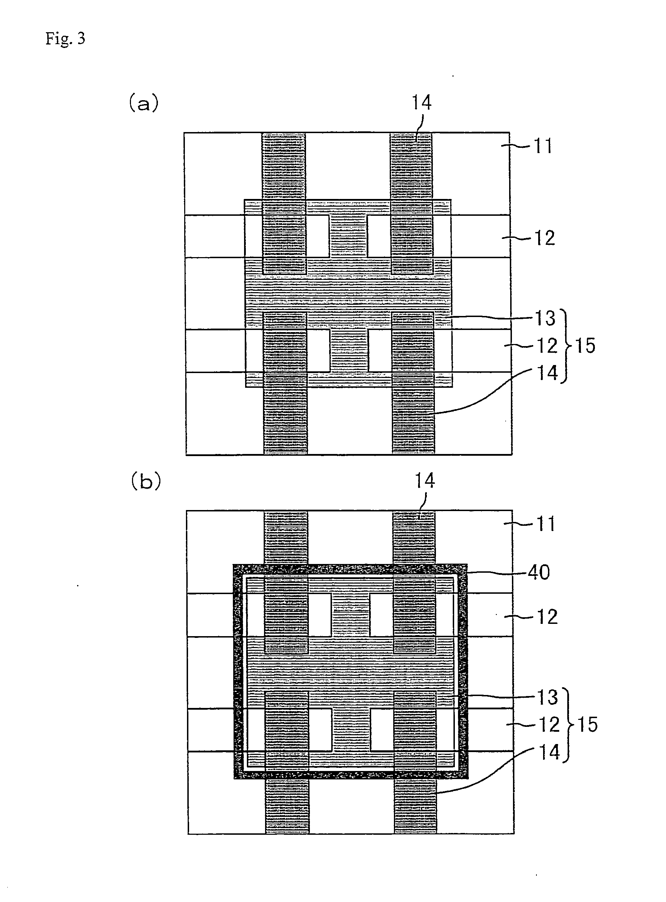

   Fig. 3(a) is a plan view schematically illustrating a substrate illustrated in Fig. 2-1(c), and Fig. 3(b) is a plan view schematically illustrating s substrate with a sealing seal applied thereto.
[Fig. 4]

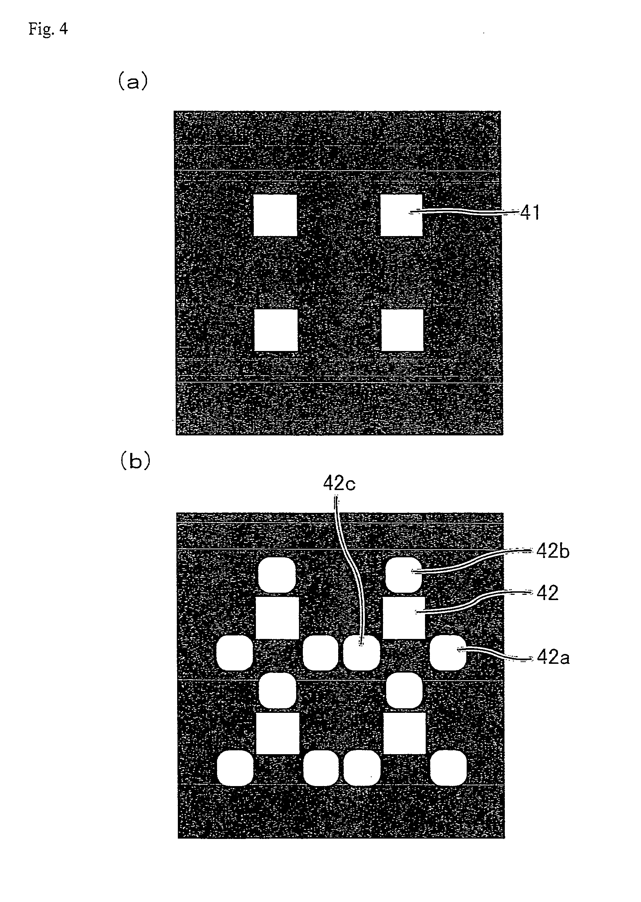

   Fig. 4(a) a plan view schematically illustrating an illuminated organic EL display device of Embodiment 1, and Fig. 4(b) a plan view schematically illustrating an illuminated organic EL display device of Comparative Embodiment 1.
[Fig. 5]

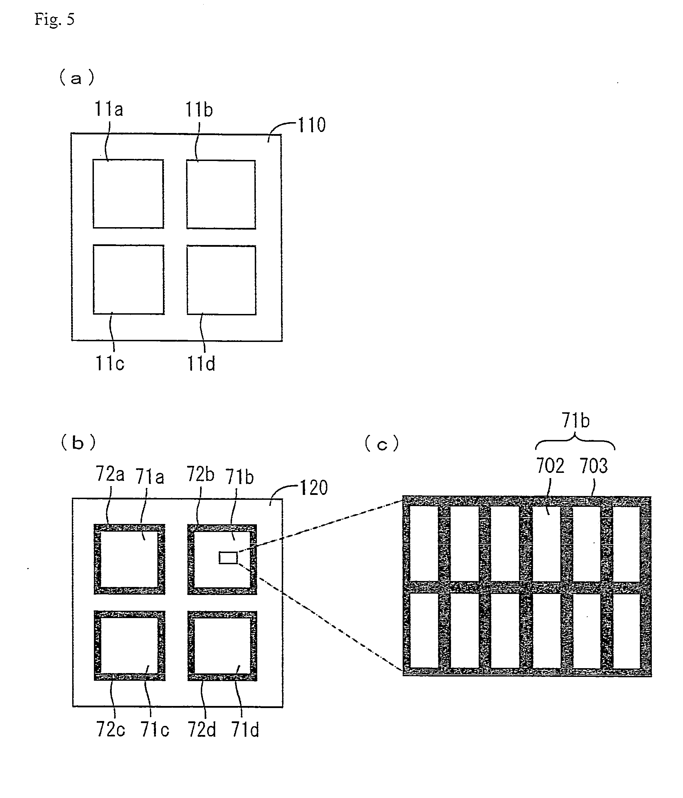

   Fig. 5(a) is a plan view schematically illustrating an example of taking four pieces from one substrate of Embodiment 3, Fig. 5(b) is a plan view schematically illustrating a mother substrate for forming color filter substrates, and Fig. 5(c) is an enlarged view of a main part illustrating part of multiple color filters contained in the color filter substrate.

### EMBODIMENTS FOR CARRYING OUT THE INVENTION

The present invention will be mentioned in more detail in the following embodiments, but is not limited to these embodiments.

### Embodiment 1

Hereinafter, the present embodiment will be described referring to Fig. 1 to Fig. 4. First, the main configuration of an organic EL display device of the present embodiment will be described referring to Fig. 1. Fig. 1(a) is a cross-sectional view illustrating the configuration of the organic EL display device of the present embodiment.

In Fig. 1(a), an organic EL display device 101 is configured such that a component placement substrate 10 and an auxiliary substrate 20 as a circuit board, which have been produced individually, are pasted together via a conductive paste 30. A sealing glass 50 is formed via a sealing seal 40 on a face of the component placement substrate opposite to the auxiliary substrate 20, and the sealing glass 50 is disposed at a spot-facing formed in the central part of the auxiliary substrate 20.

The component placement substrate 10 has a corner cube array 11 as a light-scattering layer. The corner cube array 11 is an optical member for scattering light from a light-emitting layer 13 mentioned later, and disposed on a transparent electrode 12 side. An ultraviolet curing resin is suitably used as a material of the corner cube array 11. Thermosetting inorganic materials such as a thermosetting resin and an SOG (Spin on glass) may also be used as a material of the corner cube array 11, as long as it is colorless and transparent in a visible light range and has reliability including mechanical tolerance, light resistance, and weather resistance, after curing.

An organic EL element 15 is disposed on the main surface of the irregularities of the corner cube array 11. The organic EL element 15 comprises in this order, the transparent electrode (ITO) 12 to function as an anode, the light-emitting layer 13, and a reflective electrode (metal film) 14 to function as a reflective electrode. In addition to the light-emitting layer, a hole transport layer, a hole injection layer, an electron transport layer, an electron injection layer, and the like may be contained.

A region R1 including the transparent separation layer 16 and a region R2 not including the transparent separation layer 16 are disposed on the main surface of the corner cube array 11 opposite to the side including the organic EL element 15. Since the transparent separation layer 16 in a display region is transparent, light emission efficiency is not impaired.

On the main surface of a substrate, such as a glass substrate and a plastic plate, the auxiliary substrate 20 comprises circuits (not illustrated), such as a TFT element, a gate line, and a source line, which drive the organic EL element 15. The component placement substrate 10 and this auxiliary substrate 20 having the above configurations are electrically connected via a conductive paste 30 applied between both of the substrates. The conductive paste 30 is made of a plastic deformable material, and it is preferable to cause plastic deformation due to a pressure upon pasting the component placement substrate 10 and the auxiliary substrate 20 together.

In the organic EL display device 101 having the above configuration according to the present embodiment, air on the observation face side of the component placement substrate 10 functions as a low refractive index layer, leading to improvement in extraction efficiency of light emission. In addition, the component placement substrate 10 and the auxiliary substrate 20 are connected via the conductive paste 30 having plastic deformability. Accordingly, a sure and low-resistance electrical connection can be achieved. Moreover, even in the case where a distance between both of the substrates varies upon pasting together the substrates, an electrical connection is easily secured, and therefore a design allowable error of the distance between the substrates can be large, resulting in excellent mass productivity.

Each component of the organic EL display device illustrated in Fig. 1(a) and 1(b) has been described above. The organic EL display device of the present embodiment may contain components other than the components illustrated in Figs. 1(a) and 1(b). Part of the configurations of the organic EL display device illustrated in Figs. 1(a) and 1(b) are simplified, and various changes or modifications can be made.

In the description, the corner cube array 11 has been mentioned as an example of the light-scattering layer. The light-scattering layer is not limited to the corner cube array 11 in the present invention, and a scattering substrate may be applicable as the light-scattering layer.

In the present embodiment, as illustrated in Fig. 1(b), a front substrate 17 as a protective substrate may be pasted together with a component placement substrate 10 via a sealing agent 19, whereby an organic EL display device 102 is formed. Also in such a configuration, an air layer to function as a low refractive index layer is formed between the front substrate 17 and the transparent separation layer 16, and therefore the same effects as the above effects can be exerted. Examples of the front substrate 17 include a color filter substrate, in addition to a glass substrate and a resin film. Examples of the sealing agent 19 include a sealing agent including a filler having a diameter of 5 µm. Since the light-emitting layer 13 is vulnerable to heat, it is preferable to use a photocurable sealing agent, not a thermosetting sealing agent, as the sealing agent 19.

An example of pasting the component placement substrate 10 to the auxiliary substrate 20 including the TFT and to the sealing glass 50 has been described. The present invention is not limited to the example, and an active matrix substrate which includes a TFT element and is an integrated substrate between the auxiliary substrate 20 and the sealing glass 50 may also be used.

Hereinafter, an example of the production method of the organic EL element according to the present embodiment will be specifically described referring to Fig. 2-1, Fig. 2-2, and Fig. 3. Figs. 2-1 and 2-2 are cross-sectional views schematically illustrating the production process of the organic EL display device of the present embodiment, and Fig. 3 is a plan view schematically illustrating a component placement substrate in the production process. In the production process of the organic EL display device according to the present embodiment, the technique of separating the organic EL element formed on the supporting substrate from the supporting substrate and pasting the organic EL element to another substrate is applied. As illustrated in Fig. 2-1(a), a polyimide film having a thickness of 40 nm to 200 nm was first formed on the main surface of the supporting substrate 60 made of a glass substrate, and thereafter a resin layer for forming a transparent separation layer 16 was formed. Hereinafter, this resin layer is referred to as a transparent resin layer 18 to be distinguishable from the transparent separation layer 16 illustrated in Figs. 1(a) and 1(b).

Subsequently, as illustrated in Fig. 2-1(b), the corner cube array 11 was formed on the transparent resin layer 18. The corner cube array 11 was formed by transfer molding in the 2P process (photopolymer process) with a UV curable transparent acrylic resin (produced by Mitsubishi Rayon Co., Ltd., brand: MP107). The corner cube array 11 had a thickness d1 of about 10 µm in a depression (thin portion) and a thickness d2 of about 30 µm in a projection (thick portion).

Subsequently, the transparent electrode (produced by Idemitsu Kosan Co., Ltd., registered trademark: IZO) 12, the light-emitting layer 13, and the reflective electrode (aluminium metal film) 14 are sequentially formed on the corner cube array 11 in a desired shape to produce a substrate including the organic EL element 15 as illustrated in Fig. 2-1(c). Fig. 2-1(c) is a cross-sectional view schematically illustrating an organic EL element 15 having a three-layer structure for convenience. In fact, the organic EL element 15 has a three-layer structure, not on the entire surface of the corner cube array 11, but on part thereof, as illustrated in Fig. 3(a).

Fig. 3(a) is a plan view schematically illustrating a substrate illustrated in Fig. 2-1(c), and is a 25-mm-square region on the corner cube array 11. A transparent electrode (ITO) 12 with a width of 2 mm and a length of 10 mm is formed in this region at four locations. A 13-mm-squre light-emitting layer 13 is formed in the central part of this region so as to cover part of the transparent electrode 12. A reflective electrode 14 with a width of 2 mm and a length of 10 mm is formed at four locations. The transparent electrode 12 and the reflective electrode 14 are orthogonally disposed. The transparent electrode 12, the light-emitting layer 13, and the reflective electrode 14 are each formed in the aforementioned pattern. Thereby, the organic EL element 15 is formed on the main surface of the substrate.

As illustrated in Fig. 3(b), a sealing seal 40 was applied to a 17-mm-square region on the main surface of the corner cube array 11 including the organic EL element, and a sealing glass 50 was pasted thereto via the sealing seal 40.

Subsequently, by using a dispenser, a silver paste, a conductive paste 30 (produced by Toyobo Co., Ltd., brand: DW-351H-30, mode of cure: thermosetting, filler: silver), was applied to the periphery of the spot-facing part formed in an auxiliary substrate 20. At this time, the conductive paste 30 kept a hemispherical shape (inverted bowl shape).

Subsequently, the sealing glass 50 is disposed in the spot-facing part, the corner cube array 11 including the organic EL element 15 and the auxiliary substrate 20 were pasted together under pressure, and the organic EL element 15 and an electrode extracted around the auxiliary substrate 20 were electrically connected. Thereby, a substrate illustrated in Fig. 2-1(d) was produced.

Subsequently, ultraviolet (UV) laser was applied in order to facilitate separation of the transparent resin layer 18. This laser is excimer laser. As illustrated in Fig. 2-2(e), upon laser application, a polyimide resin (produced by E. I. du Pont de Nemours and Company, trade name: Kapton tape) 80 for absorbing UV light was first provided on a face of the supporting substrate 60 opposite to a face including the transparent resin layer 18 so as to have substantially the same size as the region surrounded by the sealing seal 40. By using the polyimide resin 80 as a mask, ultraviolet rays 81 having a wavelength of 310 nm were applied from the supporting substrate 60 side. Thereby, a UV-irradiated resin layer 18a and a non-UV-irradiated resin layer 18b protected by the mask were formed in the transparent resin layer 18.

While the UV-irradiated resin layer 18a was modified and colored, the adhesion between the supporting substrate 60 and the corner cube array 11 became weaker. Then, the supporting substrate 60 was separated by mechanical external force while utilizing the UV-irradiated resin layer 18a as the starting point of separation. As a result, substantially all of the resin layer 18a was separated from the corner cube array 11 together with the supporting substrate 60. The reason why the resin layer 18a remained adhered to the supporting substrate 60 side and was separated from the corner cube array 11 together with the supporting substrate 60 was presumably that the resin layer 18a had higher adhesion to the supporting substrate 60 made of a glass substrate, than to the corner cube array 11 made of acrylic resin.

As a result, as illustrated in Fig. 2-2(f), only the non-UV-irradiated resin layer 18b remained on the face of the corner cube array 11 opposite to the face including an element, and an organic EL display device 101 including the transparent separation layer 16 was produced.

As illustrated in Fig. 2-2(g), on the face of the corner cube array 11 opposite to the face including the element, a front substrate 17 may be disposed via another clearance spacedly from the transparent separation layer 16 if necessary.

Thus, according to the method of producing the organic EL display device of the present embodiment, even in an organic EL display device having a film configuration of the bottom emission type conventionally difficult to form, a gas layer as a low refractive index layer may be formed in the vicinity of the light-emitting layer in a simple process. In addition, by partial laser application, the resin layer 18b such as a display region requiring transparency remained without impairing transparency, and the colored resin layer 18a is separated. Accordingly, the extraction efficiency from the light-emitting layer 13 is not impaired.

The light-emitting layer 13 was not damaged due to partial application of laser to the portion other than the display portion in a plane including display elements. Because of mechanical external force for separation of the supporting substrate 60 applied after the partial application of laser, the supporting substrate 60 can be readily separated in a high yield, and the productivity can be improved compared with the case of only applying a mechanical technique.

The organic EL display element produced as mentioned above was illuminated, and light emission was confirmed. Fig. 4(a) is a plan view schematically illustrating an illuminated organic EL display element. In Fig. 4(a), no light was observed except for four 2-mm-square light emissions 41, and therefore it was found that almost no emitted light was scattered. This is because a guided component of light was emitted at almost the same place as a light emission point. The light emission 41 was brighter than light emission of an organic EL display element of Comparative Embodiment 1 mentioned later. This proves that the extraction efficiency was effectively improved.

### Comparative Embodiment 1

In order to confirm the effects of the UV irradiation in Embodiment 1, the present comparative embodiment was performed as follows. That is, an organic EL element was produced as in Embodiment 1, except that the laser application step illustrated in Fig. 2-2 (e) was not performed. However, it was difficult to separate the supporting substrate 60, and the transparent resin layer 18 remained on almost the entire face of the corner cube array 11.

In Embodiment 1, the supporting substrate 60 was favorably separated. This proves that UV irradiation facilitated the separation. It is presumably because when resin in the portion to be separated is modified by UV irradiation to be readily separated, the modified portion is separated, which then facilitates mechanical separation.

The organic EL display element of the present comparative embodiment was illuminated, and light emission was confirmed. Fig. 4(b) a plan view schematically illustrating an illuminated organic EL display element. In Fig. 4(b), there are four 2-mm-square light emissions 42 and three light emissions 42a to 42c around each of the four light emissions. The light emissions 42a to 42c are 2 to 3 mm away from the center of the light emissions 42 (light emission points). The region including the light emissions 42a to 42c around the light emission 42 is therefore larger than one pixel of the display element. Accordingly, this guided component of light may not be used effectively for display. Light emissions were thus divided into multiple points, and therefore the light emissions 42 were darker than the light emissions 41 according to Embodiment 1 illustrated in Fig. 4(a).

### Embodiment 2

The present embodiment describes an organic EL display device with use of a color filter substrate as a protective substrate. In the laser application step in the present embodiment, the color filter substrate is used as a mask instead of a polyimide resin (Kapton tape) 80 used in Embodiment 1.

In the color filter substrate, a combination of color layers for color display such as red (R), green (G), and blue (B) color filter layers is typically disposed in each pixel on a substrate such as a glass substrate and a plastic substrate, and a black matrix (BM) in a lattice form is provided as a black color filter layer so as to partition each color layer for color display.

A polyimide film is formed in the color filter substrate having the above configuration and used as a mask, so that a resin in the region covered with the R, G, and B color filter layers is UV-irradiated, and a resin in the region covered with BM is not UV-irradiated. As a result, in the subsequent separation step, the resin in the region covered with the color filter layers is separated, and the resin in the region covered with BM remains as a transparent separation layer 16.

After the separation step, the color filter substrate used as a mask is pasted as a front substrate 17, and thereby a gas layer, a low refractive index layer, is formed between the color filter layer and the corner cube array, leading to improvement in the extraction efficiency from the light-emitting layer 13.

Thus, according to the present embodiment, the transparent resin layer 18 can be modified by using a color filter substrate as a mask in the laser application step illustrated in Fig. 2-2(e). It is unnecessary to paste the polyimide resin (Kapton tape) 80 to a supporting substrate 60 to be separated, and the supporting substrate 60 is readily reused.

### Embodiment 3

The present embodiment exemplifies the case where multiple organic EL display devices are formed at once with a large supporting substrate upon application of an organic EL element to a display device.

Fig. 5(a) is a plan view schematically illustrating an example of four pieces extraction in which four supporting substrates 11a to 11d are formed from a large supporting substrate 110, Fig. 5(b) is a plan view schematically illustrating a mother substrate for forming a color filter substrate, and Fig. 5(c) is an enlarged view of a main part illustrating part of multiple color filters contained in the color filter substrate. An organic EL element is formed in each of the supporting substrates 11a to 11d in the same manner as in the steps illustrated in Fig. 2-1(a) to Fig. 2-1(c) in Embodiment 1. A sealing seal 40 is applied to each of the supporting substrates 11a to 11d and pasted to a sealing glass 40. The sealing glass 40 may be individually disposed so as to correspond to each of the supporting substrates 11a to 11d, or multiple sealing glasses 40 may be disposed on a large mother substrate.

Subsequently, in the same manner as in the step illustrated in Fig. 2-1(d), the supporting substrates 11a to 11d are pasted to an auxiliary substrate 20 via a conductive paste 30. Although not illustrated, in the auxiliary substrate 20, a circuit and a spot-facing are formed so as to correspond to each of the supporting substrates 11a to 11d.

Subsequently, laser is applied as in the step illustrated in Fig. 2-2(e). As a mask for laser application, a color filter substrate is used as in Embodiment 2. Although the color filter substrate may be individually disposed on each of the supporting substrates 11a to 11d, a mother substrate 120 in which four color filter substrates 71a to 71d are disposed so as to face each of the supporting substrates 11a to 11d as illustrated in Fig. 5(b) makes it easier to dispose color filter substrates.

Upon laser application, it is effective to UV-irradiate a region outside a display area of the display device, that is, a region outside frame BMs 72a to 72d in Fig. 5(b). Alternatively, laser may be applied to a region between each pixel in the display region, or both of the laser applications may be combined.

Upon laser application to a region between each pixel, the BMs formed in the color filter substrates 71a to 71d may be used as light-shielding portions. Specifically, as illustrated in Fig. 5(c), the color filter substrates 71a to 71d include color filters 702 in each pixel. A BM 703 partitions adjacent pixels, and therefore laser is applied by using the BM 703 as a light-shielding portion. In the case where laser irradiation is UV irradiation, a polyimide film that absorbs ultraviolet rays is preferably provided on the color filter 702.

Subsequently, the supporting substrates 11a to 11d, that is, a supporting substrate 110, are separated. In the present embodiment, resin contained in the transparent resin layer 18 is modified by preliminary partial laser application, and therefore the subsequent mechanical separation facilitates separation in a high yield even in the case of using such a large substrate.

After the separation of the supporting substrate 110, the color filter substrates 71a to 71d and the like are formed if necessary, and four organic EL display devices are provided at once by separating each display device.

Thus, according to the present embodiment, even in the case where multiple organic EL element substrates are disposed on one large substrate, the transparent resin layer can be readily modified in a desired portion by using a color filter substrate as a mask in the laser application step illustrated in Fig. 2-2(e). It is not necessary to paste the polyimide resin (Kapton tape) 80 to the supporting substrate 110 to be separated, and therefore the supporting substrate 110 is readily reused. In addition, a combination of modification of resin by partial laser application and separation by application of mechanical external force enables separation in a high yield even upon use of a large substrate. As a result, in multiple organic EL display devices, a gas layer as a low refractive index layer can be formed at once in the vicinity of the light-emitting layer.

The present application claims priority to Patent Application No. 2009-001935 filed in Japan on January 7, 2009 under the Paris Convention and provisions of national law in a designated State, the entire contents of which are hereby incorporated by reference.

### EXPLANATION OF NUMERALS AND SYMBOLS

10 Component placement substrate
11 Corner cube array
12 Transparent electrode
13 Light-emitting layer
14 Reflective electrode
15 Organic EL element
16 Transparent separation layer
17 Front substrate
18 Transparent resin layer
18a, 18b Resin layer
19 Sealing agent
20 Auxiliary substrate
30 Conductive paste
40 Sealing seal
41, 42, 42a to 42c Light emission
50 Sealing glass
60, 110, 11a to 11d Supporting substrate
71a to 71d Color filter substrate
80 Polyimide resin
81 Ultraviolet rays
101, 102 Organic EL display device
120 Mother substrate
702 Color filter
703 BM
d1 Thickness of depression
d2 Thickness of projection

## Claims

1. An organic electroluminescent display device, comprising:
a component placement substrate having an organic electroluminescence element;
a circuit board having a driver circuit for the organic electroluminescence element, the component placement substrate and the circuit board being joined to each other; and
a conductor in a clearance between the component placement substrate and the circuit board,
the component placement substrate comprising in this order from an observation face side:
a transparent separation layer;
a light-scattering layer;
a transparent electrode;
a light-emitting layer; and
the reflective electrode,
wherein the conductor electrically connects the reflective electrode to an electrode of the driver circuit.

2. The organic electroluminescent display device according to claim 1, further comprising:
a protective substrate disposed via an other clearance spacedly from the transparent separation layer on the observation face side; and
a gas layer formed between the component placement substrate and the protective substrate,
wherein the transparent separation layer is partially formed on the light-scattering layer.

3. The organic electroluminescent display device according to claim 1 or 2,
wherein the gas layer is an air layer.

4. The organic electroluminescent display device according to claim 2 or 3,
wherein the protective substrate is a glass substrate or a resin film.

5. The organic electroluminescent display device according to any one of claims 2 to 4,
wherein the protective substrate is a color filter substrate.

6. The organic electroluminescent display device according to any one of claims 1 to 5,
wherein the transparent separation layer has a thickness of 40 nm to 300 nm.

7. The organic electroluminescent display device according to any one of claims 1 to 6,
wherein the light-scattering layer is a corner cube array.

8. A method for producing an organic electroluminescent display device,
the organic electroluminescent display device comprising:
a component placement substrate having an organic electroluminescence element; and
a circuit board having a driver circuit for the organic electroluminescence element, the component placement substrate and the circuit board being joined to each other;
the method comprising the steps of:
forming a transparent separation layer on a main surface of a supporting substrate;
forming a light-scattering layer on the transparent separation layer;
forming an organic electroluminescence element comprising a transparent electrode, a light-emitting layer, and a reflective electrode in this order on the light-scattering layer;
disposing a conductor material on at least one of a surface on a side of the supporting substrate including the organic electroluminescence element and a main surface of the circuit board;
pasting together the component placement substrate and the circuit board so that the reflective electrode and the electrode of the driver circuit are connected via the conductor material;
applying a laser to part of the transparent separation layer from a side of a main surface of the supporting substrate opposite to the side including the organic electroluminescence element to modify the part of the transparent separation layer; and
separating the supporting substrate from the modified part of the transparent separation layer.

9. The method for producing an organic electroluminescent display device according to claim 8,
wherein the laser application step includes applying a laser via a mask on an outer edge of a display region of the display device and/or between pixel regions in the display region.

10. The method for producing an organic electroluminescent display device according to claim 9,
wherein a color filter is used as the mask.
